# EUROPÄISCHE PATENTSCHRIFT

(11) **EP 1 119 899 B1**
(45) Veröffentlichungstag und Bekanntmachung des Hinweises auf die Patenterteilung: **02.10.2002**
(21) Anmeldenummer: 99970217.8
(22) Anmeldetag: 02.10.1999
(51) Int. Cl.: H02M 7/00

(54) **ANORDNUNG EINES MEHRPHASIGEN UMRICHTERS**
ARRANGEMENT OF A MULTIPHASE CONVERTER
CONFIGURATION D'UN REDRESSEUR POLYPHASE

(30) Priorität: 07.10.1998 DE 19846156
(43) Veröffentlichungstag der Anmeldung: 01.08.2001
(73) Patentinhaber: ROBERT BOSCH GMBH, 70442 Stuttgart (DE)
(72) Erfinder: LANDSGESELL, Juergen, D-74076 Heilbronn (DE); EISENHARDT, Martin, D-71272 Renningen (DE)
(86) Internationale Anmeldenummer: DE9903185
(87) Internationale Veröffentlichungsnummer: WO00021187

(56) Entgegenhaltungen:
- EP-A- 0 677 916
- EP-A- 0 766 504
- WO-A-92/19013
- US-A- 5 914 860

## Beschreibung

### Stand der Technik

Die Erfindung geht aus von einem mehrphasigen Umrichter mit Halbleiter-Leistungsbauelemente und einem Kondensator, der im Oberbegriff des Anspruchs 1 definierten Gattung.

Es ist allgemein bekannt und üblich, bei mehrphasigen Umrichtern, die mit Halbleiter-Leistungsbauelementen und einem Kondensator, einem sogenannten Zwischenkreiskondensator, insbesondere ein leistungsstarker Elektrolytkondensator, ausgestattet sind, zumindest diese Bauelemente auf einem Kühlvorrichtungen enthaltenden Träger aufzubringen. Als Träger sind zum einen flache rechteckige Kühlplatinen üblich, die Kühlkanäle enthalten, durch welche ein flüssiges Kühlmittel fließt. Zum anderen sind flache, rechteckförmige Träger üblich, auf deren einer Seite die Bauelemente befestigt sind und auf deren anderer Seite Kühllamellen oder Kühlrippen zur Luftkühlung vorgesehen sind. Da bei Umrichtern höherer Leistung ein recht großer Kondensator als sogenannter Zwischenkreiskondensator vorgesehen sein muß, für den im allgemeinen ein Elektrolytkondensator verwendet wird, ist die Bauhöhe senkrecht zum Träger durch dessen relativ große Höhe bestimmt und die flächenmäßige Ausdehnung des Trägers sowohl von der Grundfläche des Kondensators als auch additiv von den zu kühlenden relativ großen, notwendigen Anbauflächen der LeistungsHalbleiter bestimmt. Dadurch bedarf ein solcher Umrichter sowohl flächenmäßig als auch in der Höhe erheblichen Platz. Dieser Platzbedarf ist nicht in jeder Anwendung vorhanden.

Eine solche Stromrichteranlage mit flüssigkeitsgekühlten Leistungshalbleitern ist aus der EP-A 0 677 916 bekannt. Dort wird eine Stromrichteranlage mit einem eine Kondensatorbatterie aufweisenden Gleichspannungszwischenkreis vorgeschlagen, bestehend aus mindestens einem Stromrichtermodul, dessen elektrische Modulanschlüsse in einer Reihe angeordnet und mit einem ersten induktivitätsarmen Verbindungsschienensystem kontaktierbar sind. Die Kondensatorbatterie ist dem Stromrichtermodul mechanisch zugeordnet und ihre elektrischen Anschlüsse liegen an einem zweiten, die Gleichspannungszwischenkreis-Leitungen enthaltenden, senkrecht zum ersten Verbindungsschienensystem angeordneten, induktivitätsarmen Verbindungsschienensystem, das mit dem ersten Verbindungsschienensystem elektrisch in Verbindung steht.Bei einer mindestens zwei Stromrichtermodule enthaltenden Anlage ist die Gesamt-Kondensatorbatterie des Gleichspannungszwischenkreises in einzelne, jeweils den einzelnen Stromrichtermodulen mechanisch zugeordnete Teil-Kondensatorbatterien aufgeteilt und die zweiten Verbindungsschienensysteme benachbarter Module sind jeweils über elektrische Kupplungen miteinander verbunden.

Die Aufgabe vorliegender Erfindung besteht in der Anordnung der Bauelemente in der Weise, daß gegenüber der bekannten Bau- und Anordnungsweise erheblich weniger Platz in Anspruch genommen wird.

### Vorteile der Erfindung

Die erfindungsgemäße Anordnung der Bauelemente eines Umrichters mit den kennzeichnenden Merkmale des Anspruchs 1 hat gegenüber der bekannten Bau- und Anordnungsweise den Vorteil, bei gleicher Leistung wesentlich weniger Platz in Anspruch zu nehmen und dabei auch noch eine wesentlich intensivere Kühlung des Kondensators sicher zu stellen. Die Erfindung packt die Bauelemente unter wesentlich verbesserter Raumausnutzung kompakt zusammen. Ein gegebenes Raumvolumen, insbesondere im wesentlichen in zylindrischer Form, und die Kühlung wird optimal ausgenutzt.

Bei der Anordnung eines mehrphasigen Umrichters gemäß der Erfindung ist dazu der Träger als Hohlkörper ausgebildet, in seinem Inneren ist möglichst eng und paßgenau der Kondensator oder eine Anordnung von parallel geschalteten Kondensatoren einsetzbar vorgesehen, und auf seiner Außenseite sind die Halbleiter-Leistungsbauelemente angeordnet. Somit sind die Halbleiter-Leistungsbauelemente um den Kondensator herum als Zentrum angeordnet, getrennt durch den als Träger fungierenden Kühlkörper.

Durch die in den weiteren Ansprüchen niedergelegten Maßnahmen sind vorteilhafte Weiterbildungen und Verbesserungen der im Anspruch 1 angegebenen Anordnung möglich.

Entsprechend einer besonders zweckmäßigen Ausgestaltung der Erfindung ist der Hohlkörper derart ausgebildet, daß er im wesentlichen zylindrische oder quaderförmige Gestalt auf der Außenseite und zylindrische Gestalt bzw. an die Außenform der Kondensatoranordnung angepaßte Gestalt auf seiner Innenseite aufweist. In weiterer Verbesserung dieser Ausgestaltung ist der Hohlkörper auf seiner Außenseite mit geeigneten Flächen versehen, auf denen die Halbleiter-Leistungsbauelemente in gutem Wärmeleitkontakt mit dem kühlbaren Hohlkörper anbringbar sind.

In besonders zweckmäßiger Weiterbildung dieser Ausgestaltung der Erfindung, die eine besonders einfache und übersichtliche Bauform bereitstellt, ist der Hohlkörper mit flachen Flächen versehen, und es sind insbesondere bei zweiphasigem Umrichter vier und bei dreiphasigem Umrichter sechs flache Außenflächen vorgesehen. Somit können die zu einer Brückenhälfte bzw. zu einem Brückendrittel gehörenden Bauteile sehr übersichtlich und ansprechend in Form eines Quaders oder annähernd zylinderförmig um den kühlenden Träger angeordnet werden, während im Zentrum der Kondensator bzw. die Kondensatoranordnung sitzt und ebenfalls gekühlt werden kann. Diese kompakte Anordnung wird weiterhin dadurch verbessert, daß der Hohlkörper in axialer Richtung im wesentlichen so lang ausgeführt ist, wie es der Länge des Kondensators bzw. der Kondensatoranordnung entspricht.

In besonders vorteilhafter und zweckmäßiger Weiterbildung der Erfindung ist eine quaderförmige oder zylindrische Abdeckung vorgesehen, welche den als Träger dienenden Hohlkörper zusammen mit den in ihm und an ihm angebrachten Bauelementen, bis auf notwendige Anschlußkontakte, abschließend umgibt. Damit sind die Bauteile gegen von außen einwirkende Einflüsse geschützt und es ist damit ein in sich abgeschlossenes anschließbares und einbaufähiges, sehr kompaktes Bauteil zur Verfügung gestellt.

Gemäß einer weiteren sehr vorteilhaften und zweckmäßigen Ausgestaltung der Erfindung dient der Hohlkörper auch als Träger für elektrische Platinen. So sind entsprechend einer Ausführungsform elektrische Ansteuerplatinen für die Halbleiter-Leistungsbauelemente auf der Außenseite der Halbleiter-Leistungsbauelemente und deren elektrischen Verbindungsleitungen vorgesehen. In vorteilhafter Weiterbildung dieser Ausführungsform können elektrische Steuerplatinen an einer oder beiden Stirnseiten des hohlkörperförmigen Trägers vorsehbar und anbringbar sein.

In vorteilhafter Weiterbildung der erfindungsgemäßen Anordnung ist der Hohlkörper mit geeigneten und geeignet angeordneten Kühlkanälen versehen und durch diese Kühlkanäle ist ein Kühlmittel, insbesondere ein flüssiges, treibbar. In zweckmäßiger Ausgestaltung dieser Weiterbildung ist der Hohlkörper an einer Stirnseite mit einem Kühlkanäle enthaltenden Trägerteil versehen, durch welches in der äußeren Trägerwand vorgesehene Kühlkanäle miteinander verbindbar sind und wodurch der Hohlkörper eine Topfähnliche Form erhält. Der im Inneren vorgesehene Kondensator ist somit in sehr günstiger Weise fast auf seiner ganzen Außenseite vom kühlenden hohlköperförmigen Träger umgeben.

Die erfindungsgemäße Anordnung wird in sehr zweckmäßiger Weise in verschieden Anwendungen verwendet, insbesondere ist sie zur Verwendung in einem Kraftfahrzeug oder in einem Elektrofahrzeug oder in einem Hybridfahrzeug oder in einem Starter-Generator-Antrieb vorgesehen und geeignet.

### Zeichnung

Die Erfindung ist anhand eines in der Zeichnung dargestellten Ausführungsbeispieles in der nachfolgenden Beschreibung näher erläutert. Dabei zeigen
- Fig. 1: schematisch in einer Draufsicht die erfindungsgemäße Anordnung, wobei im dargestellten Beispiel eines dreiphasigen Umrichters der tragende Hohlkörper innen zylindrich gestaltet und außen mit sechs flachen Flächen in Form eines regelmäßigen Sechseckes versehen ist;
- Fig. 2: schematisch in Seitenansicht und teilweise im Schnitt die in Fig. 1 dargestellte Anordnung eines dreiphasigen Umrichters, und
- Fig. 3: schematisch ein elektrisches Schaltbild der dreiphasigen Brückenschaltung mit den zugehörigen Halbleiter-Leistungsbauelementen, die der Anordnung der Bauteile des in Fig. 1 und 2 dargestellten Umrichters zugrunde liegt.

### Beschreibung des Ausführungsbeispiels

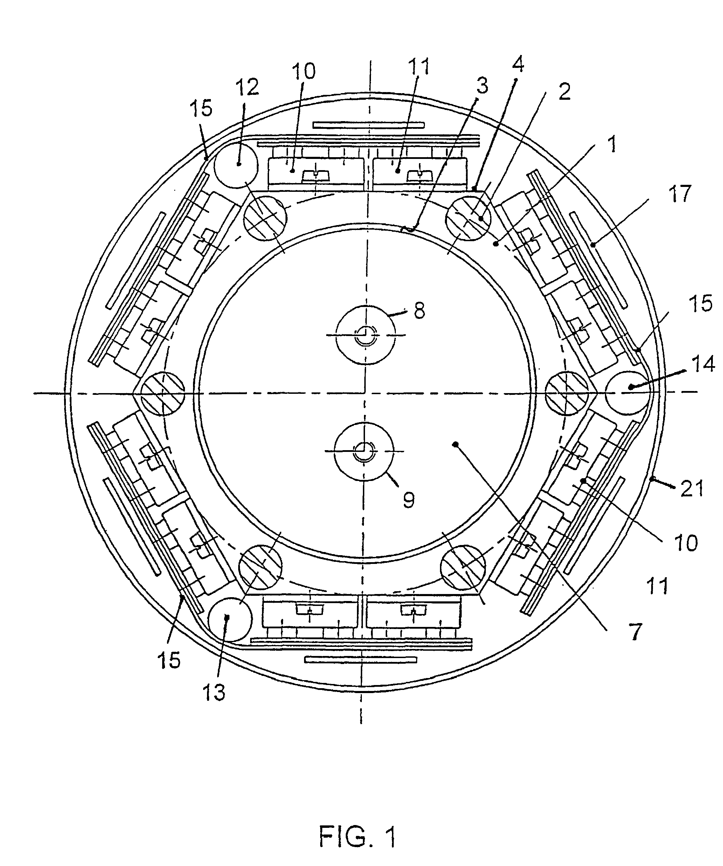

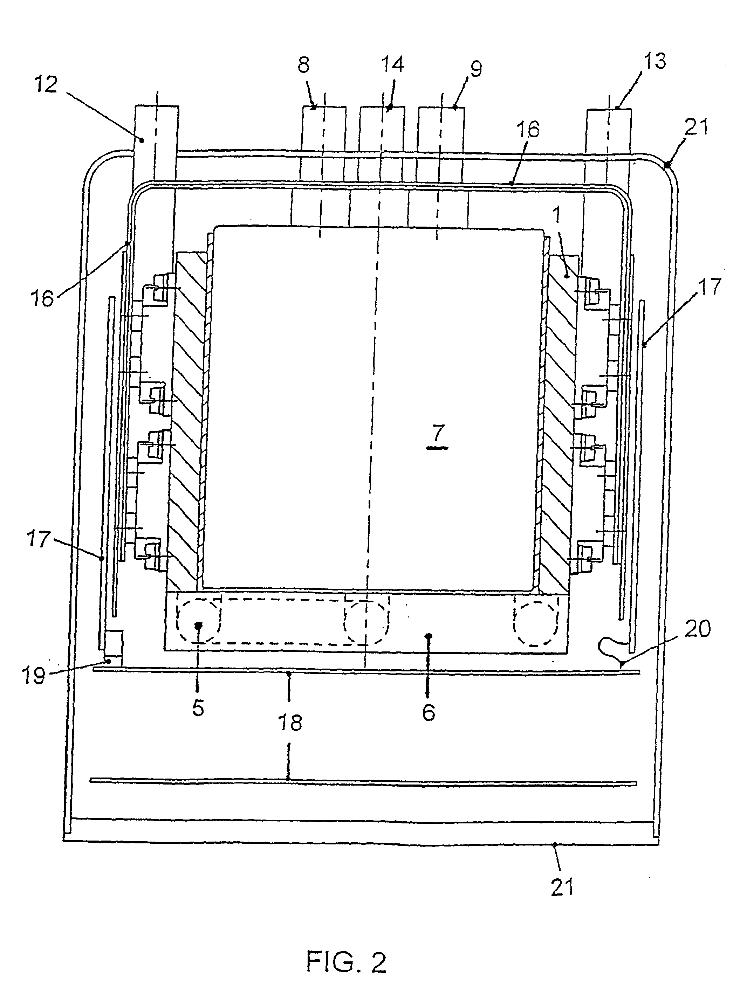

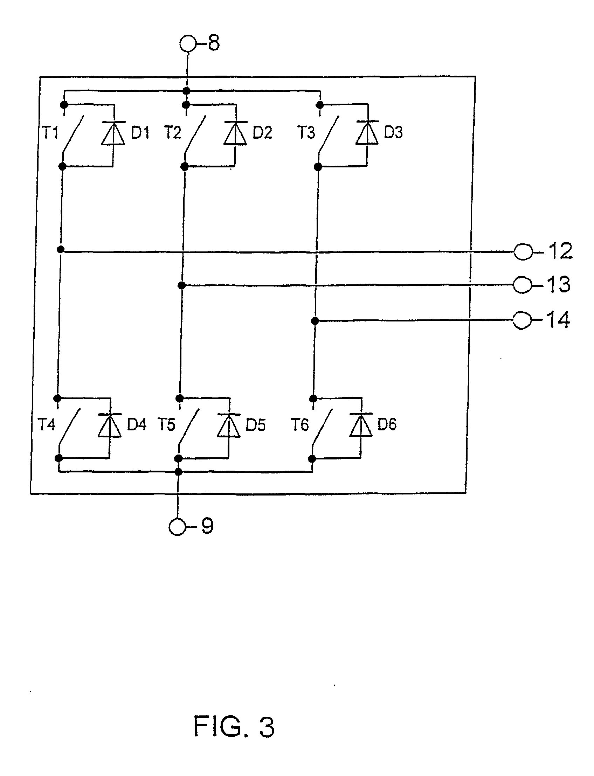

Die erfindungsgemäße Anordnung der Bauelemente eines Umrichters ist schematisch in einer Draufsicht in Fig. 1 und in einer Seitenansicht und teilweise im Schnitt in der Fig. 2 dargestellt. Das dargestellte Ausführungsbeispiel geht von einem dreiphasigen Umrichter aus, dessen elektrisches Schaltbild der zugehörigen dreiphasigen Brückenschaltung mit den dazu notwendigen HaLbleiter-Leistungsbauelementen in der Fig. 3 dargestellt ist.

Ein als Hohlkörper ausgebildeter Träger 1 ist mit Kühlkanälen 2 versehen und auf seiner Innenseite 3 zylinderförmig und auf seiner Außenseite 4 als Sechskant ausgebildet. Dadurch entsteht auf der Außenseite 4 des hohlkörperförmigen Trägers 1 eine im wesentlichen zylindrische Gestalt. Wie in Fig. 2 dargestellt ist, kann der hohlkörperförmige Träger 1 an einer Stirnseite mit einem Kühlkanäle 5 enthaltendes Trägerteil 6 versehen sein. Durch dieses Trägerteil 6 erhält der Hohlkörper eine topfähnliche Form und es ist die Möglichkeit gegeben, durch das Trägerteil 6 und seine Kühlkanäle 5 die in der Wand des Trägers 1 enthaltenen Kühlkanäle 2 miteinander zu verbinden. Die Kühlkanäle 2 in dem hohlkörperförmigen Träger 1 sind geeignet geformt und an geeigneter Stelle angebracht. Im dargestellten Beispiel mit der sechskantförmigen Ausgestalt sind sie vorzugsweise im Kantenbereich, dort wo die Wandstärke etwas größer ist, untergebracht.

Im Inneren des hohlkörperförmigen Trägers 1 ist ein Kondensator 7, vorzugsweise in Form eines leistungsstarken Elektrolytkondensators, möglichst paßgenau eingefügt. An der nach oben offenen Stirnseite, wie dies in Fig. 2 dargestellt ist, ragen die beiden Anschlüsse 8 und 9 für den positiven und den negativen Pol heraus. Ansonsten ist der Kondensator 7 bis auf diese Stirnseite allseitig eng von dem als Träger dienenden topfförmigen Hohlkörper 1 umgeben und dadurch dessen Kühlung voll ausgesetzt.
Auf der Außenseite des Hohlkörpers 1 sind die Halbleiter-Leistungsbauelemente 10 und 11 jeweils auf einer Fläche aufgebracht. Dabei können die mit 10 und 11 bezeichneten Halbleiter-Leistungsbauelemente beispielsweise entsprechend Fig. 3 jeweils ein Transistor T1 und eine zu ihm parallel geschaltete Diode D1 bzw. T4 und D4 sein, die einer Phase zugeordnet sind und auf zwei benachbarten Flächen angeordnet sind. Diese sind dann über eine Anschlußleitung 12 bzw. 13 bzw. 14 in dem dargestellten Dreiphasen-Umrichter nach außen geführt. So gehören beispielsweise entsprechend der Fig. 3 die Transistoren T1 und die Diode D1 sowie der Transistor T4 und die dazu parallel geschaltete Diode D4 auf der benachbarten Fläche zu der Leitung 12. Verbunden sind diese Halbleiter-Leistungsbauelemente, die zu einer Leitung, wie insbesondere Leitung 12, Leitung 13 oder Leitung 14, gehören, jeweils durch eine Busbar genannte Sammelschiene 15. Zur zweiten Phase, die an der Leitung 13 herausgeführt ist, gehört der Brückenteil mit dem Transistor T2 und der Diode D2 sowie der Transistor T5 und die ihm zugeordnete Diode D5. Dem dritten Brückenteil des Dreiphasen-Umrichters sind der Transistor T3 mit seiner Diode D3 und der Transistor T6 mit seiner Diode D6 an der Leitung 14 zugeordnet. Die jedem Brückendrittel zugeordneten Halbleiter-Leistungsbauelemente sind somit jeweils auf einer Seite der Leitung 12, 13 oder 14 auf den symmetrisch zu diesen Leitungsanschlüssen liegenden Außenflächen des Hohlkörpers 1 angeordnet und in gut Wärme leitenden Kontakt auf den entsprechenden flachen Flächen des Trägers 1 befestigt. Dies ist insbesondere gut erkennbar in der Draufsicht der Fig. 1. Der Gleichstromanschluß an den Leitungen 8 und 9 ist über eine ebenfalls Busbar genannte Sammelschiene 16, wie in Fig. 2 gut erkennbar dargestellt ist, an die Halbleiter-Leistungsbauelemente herangeführt.

Auf den Außenseiten außerhalb der Sammelschienen 15 sind, wie in Fig. 1 in der Draufsicht dargestellt und gut erkennbar, Ansteuerplatinen 17 auf jeder der sechs Flächen vorgesehen, die unmittelbar die darunter befindlichen Halbleiter-Leistungsbauelemente ansteuern. Diese sechs Ansteuerplatinen 17 sind mit einer weiteren Platine, der Steuerplatine 18, verbunden, und zwar entweder über Stecker 19 oder flexible Leiterplattenverbinder 20, wie dies links bzw. rechts in der Fig. 2 dargestellt ist. Dort ist noch eine weitere Platine 18 dargestellt, die für hier nicht relevante Zwecke mit in den Umrichter eingebaut sein kann. Diese gesamte Anordnung ist von einer Abdeckung 21 umgeben, die im dargestellten Fall zylinderförmig ist und alle Bauelemente bis auf die Leitungsherausführungen 8, 9, 12, 13, 14 voll umgibt. Damit hat man ein einbaufähiges, in sich geschlossenes und an den Leitungen 8, 9, 12, 13 und 14 anschließbares Bauteil mit einem sehr kompakt gepackten Umrichter.

Somit ist mit diesem Auführungsbeispiel und der darin gezeigten Anordnung der Leistungsbauelemente zueinander ein zylindrisches vorgegebenes Bauvolumen optimal ausgenutzt. Im Zentrum des Sechskantprofils, welches auf der Innenseite 3 zylindrisch gestaltet ist, ist der zylindrische Kondensator 7 angeordnet. Auf jeder Außenfläche 4 des Sechskantprofils des hohlkörperförmigen Trägers 1 befindet sich ein Leistungsschalter bzw. es sind mehrere parallel geschaltet und dort angebracht, des Dreiphasen-Impulswechselrichters. Wie im Ausführungsbeispiel dargestellt, liegen idealerweise die beiden Schalter einer Halbbrücke bzw. eines zueinander gehörenden Brückenteils auf benachbarten Sechskantflächen. Um einen möglichst niederinduktiven Aufbau zu erreichen, erfolgt die Verbindung der Halbbrücken über Busbar genannte Verbindungsschienen 15 bzw. 16. Die fünf Leitungsanschlüsse 8, 9, 12, 13, 15 können an jeder geeigneten Position, sei es radial oder axial, herausgeführt werden. Im dargestellten Beispiel sind sie axial an einer Stirnseite zusammen herausgeführt. Der Hohlkörper oder topfförmige Träger 1 ist in seiner axialen Erstreckung vorzugsweise so lange gestaltet, wie es durch die Bauhöhe des notwendigen Kondensators 7 vorgegeben ist.

Es sei hier darauf hingewiesen, daß in einem anderen, nicht dargestellten Ausführungsbeispiel, beispielsweise bei einem zweiphasigen Umrichter, die Gestaltung der Außenfläche des hohlkörperförmigen Trägers so vorgenommen werden kann, daß vier Außenflächen vorgesehen sind, und auf jeweils zwei benachbarten Außenflächen die Halbleiter-Leistungsbauelemente, die zu einer Halbbrücke gehören, benachbart angeordnet sind. Die Verbindung und Ansteuerung mit den jeweiligen Elementen ist dann ähnlich wie im dargestellten Ausführungsbeispiel. Hier wird dann als Abdeckung eine quaderförmige Abdeckung benutzt. Es ist jedoch gegenüber dem Stand der Technik festzuhalten, daß hier dann das gesamte durch den Quader gegebene Bauvolumen durch die Bauelemente optimal genutzt ist und nicht nur ein Teil.

Weiterhin sei angemerkt, daß anstelle des einen zentral im hohlkörperförmigen Träger 1 angeordneten Kondensators 7 eine Kondensatoranordnung, die aus einer Reihe von Kondensatoren in Parallelschaltung besteht, verwendet werden und zentral im Inneren des Hohlkörpers angeordnet werden kann. Dabei ist dann die Innenfläche des hohlkörperförmigen Trägers entsprechend optimal an die jeweils gegebene Form anzupassen und die Kühlkanäle 2 entsprechend an den geeignetsten Stellen vorzusehen.

Die Grundidee vorliegender Erfindung besteht demnach darin, zentral in einem Hohlkörper den bzw. die Kondensatoren anzuordnen und auf der Außenseite des Hohlkörpers die notwendigen Halbleiter-Bauelemente anzuordnen. Der Hohlkörper enthält in seiner Wandung die insbesondere durch eine Kühlflüssigkeit durchströmten Kühlkanäle 2 an geeigneter Stelle und kühlt sowohl die in gut wärmeleitenden Übergang auf der Außenseite angebrachten Halbleiter-Bauelemente als auch den oder die im Inneren vorgesehenen Leistungskondensatoren.

## Patentansprüche

1. Anordnung eines mehrphasigen Umrichters mit Halbleiter-Leistungsbauelementen (10, 11) und einem Kondensator (7), einem sogenannten Zwischenkreiskondensator, insbesondere ein leistungsstarker Elektrolytkondensator, wobei zumindest diese Bauelemente (7, 10, 11) auf einem Kühlvorrichtungen enthaltenden Träger (1) aufgebracht sind,
**dadurch gekennzeichnet, daß**
der Träger (1) als Hohlkörper ausgebildet ist,
in seinem Inneren möglichst eng und paßgenau der Kondensator (7) oder eine Anordnung von parallel geschalteten Kondensatoren einsetzbar vorgesehen ist, und
auf seiner Außenseite (4) die Halbleiter-Leistungsbauelemente (10, 11) angeordnet sind.

2. Anordnung nach Anspruch 1, **dadurch gekennzeichnet, daß** der Hohlkörper (1) derart ausgebildet ist, daß er im wesentlichen zylindrische oder quaderförmige Gestalt auf der Außenseite (4) und zylindrische Gestalt bzw. an die Außenform der Kondensatoranordnung angepaßte Gestalt auf seiner Innenseite (3) aufweist.

3. Anordnung nach Anspruch 1 oder 2, **dadurch gekennzeichnet, daß** der Hohlkörper auf seiner Außenseite mit geeigneten Flächen (4) versehen ist, auf denen die Halbleiter-Leistungsbauelemente (10, 11) in gutem Wärmeleitkontakt mit dem kühlbaren Hohlkörper (1) anbringbar sind.

4. Anordnung nach Anspruch 4 **dadurch gekennzeichnet, daß** der Hohlkörper (1) mit flachen Flächen (4) versehen ist, und daß insbesondere bei zweiphasigem Umrichter vier und bei dreiphasigem Umrichter sechs flache Außenflächen vorgesehen sind.

5. Anordnung nach Anspruch 1 oder einem der Ansprüche 2 bis 4, **dadurch gekennzeichnet, daß** der Hohlkörper (1) in axialer Richtung im wesentlichen so lang ausgeführt ist, wie es der Länge des Kondensators (7) bzw. der Kondensatoranordnung entspricht.

6. Anordnung nach Anspruch 1 oder einem der Ansprüche 2 bis 5, **dadurch gekennzeichnet, daß** eine quaderförmige oder zylindrische Abdeckung (21) vorgesehen ist, welche den als Träger (1) dienenden Hohlkörper zusammen mit den in ihm und an ihm angebrachten Bauelementen (7, 10, 11, 15, 16, 17, 18), bis auf notwendige Anschlußkontakte (8, 9, 12, 13, 14), abschließend umgibt.

7. Anordnung nach einem der vorigen Ansprüche, **dadurch gekennzeichnet, daß** der Hohlkörper (1) auch als Träger für elektrische Platinen (17, 18) dient.

8. Anordnung nach Anspruch 7, **dadurch gekennzeichnet, daß** elektrische Ansteuerplatinen (17) für die Halbleiter-Leistungsbauelemente (10, 11) auf der Außenseite der Halbleiter-Leistungsbauelemente (10, 11) und deren elektrischen Verbindungsleitungen (15, 16) vorgesehen sind.

9. Anordnung nach Anspruch 7 oder 8, **dadurch gekennzeichnet, daß** zumindest eine elektrische Steuerplatine (18) an einer oder beiden Stirnseiten des hohlkörperförmigen Trägers (1) vorsehbar und anbringbar ist.

10. Anordnung nach einem der vorigen Ansprüche, **dadurch gekennzeichnet, daß** der Hohlkörper (1) mit geeigneten und geeignet angeordneten Kühlkanälen (2) versehen ist und daß durch diese Kühlkanäle (2), insbesondere ein flüssiges, Kühlmittel treibbar ist.

11. Anordnung nach Anspruch 10, **dadurch gekennzeichnet, daß** der Hohlkörper an einer Stirnseite mit einem Kühlkanäle (5) enthaltenden Trägerteil (6) versehen ist, durch welches in der Wand des Trägers (1) vorgesehene Kühlkanäle (2) miteinander verbindbar sind und wodurch der hohlkörperförmige Träger (1) eine topfähnliche Form erhält.

12. Anordnung nach einem der vorigen Ansprüche, **dadurch gekennzeichnet, daß** sie zur Verwendung in einem Kraftfahrzeug oder in einem Elektrofahrzeug oder in einem Hybridfahrzeug oder in einem Starter-Generator-Antrieb vorgesehen ist.

## Claims

1. Arrangement of a multiphase converter with semiconductor power devices (10, 11) and a capacitor (7), known as an intermediate-circuit capacitor, in particular a powerful electrolytic capacitor, at least these components (7, 10, 11) being mounted on a carrier (1) containing cooling devices, **characterized in that** the carrier (1) is formed as a hollow body, in its interior the capacitor (7) or an arrangement of parallel-connected capacitors can be inserted as snugly and closely fitting as possible, and the semiconductor power devices (10, 11) are arranged on its outer side (4).

2. Arrangement according to Claim 1, **characterized in that** the hollow body (1) is formed in such a way that it has a substantially cylindrical or cuboidal shape on the outer side (4) and a cylindrical shape or shape adapted to the outer form of the capacitor arrangement on its inner side (3).

3. Arrangement according to Claim 1 or 2, **characterized in that** the hollow body is provided on its outer side with suitable areas (4) on which the semiconductor power devices (10, 11) can be mounted in good thermally conducting contact with the coolable hollow body (1).

4. Arrangement according to Claim 4, **characterized in that** the hollow body (1) is provided with flat areas (4), and **in that**, in particular in the case of a two-phase converter, four flat outer areas are provided and, in the case of a three-phase converter, six flat outer areas are provided.

5. Arrangement according to Claim 1 or one of Claims 2 to 4, **characterized in that** the hollow body (1) is made to be of substantially such a length in the axial direction that it corresponds to the length of the capacitor (7) or the capacitor arrangement.

6. Arrangement according to Claim 1 or one of Claims 2 to 5, **characterized in that** a cuboidal or cylindrical cover (21) is provided, which surrounds and closes off the hollow body serving as the carrier (1), together with the components (7, 10, 11, 15, 16, 17, 18) attached in it and on it, apart from necessary connection contacts (8, 9, 12, 13, 14).

7. Arrangement according to one of the preceding claims, **characterized in that** the hollow body (1) also serves as the carrier for electric printed circuit boards (17, 18).

8. Arrangement according to Claim 7, **characterized in that** electric drive boards (17) are provided for the semiconductor power devices (10, 11) on the outer side of the semiconductor power devices (10, 11) and their electrical connecting lines (15, 16).

9. Arrangement according to Claim 7 or 8, **characterized in that** at least one electric control board (18) can be provided on and attached to one or both end faces of the carrier (1) in the form of a hollow body.

10. Arrangement according to one of the preceding claims, **characterized in that** the hollow body (1) is provided with suitable and suitably arranged cooling channels (2) and **in that** a coolant, in particular a liquid coolant, can be driven through these cooling channels (2).

11. Arrangement according to Claim 10, **characterized in that** the hollow body is provided on its end face with a carrier part (6) which contains cooling channels (5) and by which cooling channels (2) provided in the wall of the carrier (1) can be connected to one another and whereby the carrier (1) in the form of a hollow body is given a form similar to a pot.

12. Arrangement according to one of the preceding claims, **characterized in that** it is intended for use in a motor vehicle or in an electric vehicle or in a hybrid vehicle or in a starter generator drive.

## Revendications

1. Configuration d'un redresseur polyphasé comprenant des éléments de puissance à semi-conducteurs (10, 11) et un condensateur (7) qu'on appelle un condensateur de circuit intermédiaire, en particulier un condensateur électrolytique de forte puissance, au moins ces éléments (7, 10, 11) étant montés sur un support (1) contenant des dispositifs de refroidissement,
**caractérisée en ce que**
- le support (1) est un corps creux,
- il est prévu de pouvoir insérer à l'intérieur de ce corps, de la manière la plus étroite et la mieux ajustée possible, le condensateur (7) ou un système de condensateurs connectés en parallèle,
- les éléments de puissance à semi-conducteurs (10, 11) sont disposés sur la surface externe (4) du support.

2. Configuration selon la revendication 1,
**caractérisée en ce que**
le corps creux (1) est constitué de manière que sa surface externe (4) soit essentiellement cylindrique ou parallélépipédique et que sa surface interne (3) soit cylindrique et adaptée à la forme externe du système de condensateurs.

3. Configuration selon la revendication 1 ou 2,
**caractérisée en ce que**
le corps creux présente sur sa surface externe des portées appropriées (4) sur lesquelles les éléments de puissance à semi-conducteurs (10, 11) peuvent être montés en bon contact de transfert thermique avec le corps creux (1) à refroidir.

4. Configuration selon la revendication 1,
**caractérisée en ce que**
le corps creux (1) présente des portées (4) planes et il est prévu notamment quatre portées dans le cas d'un redresseur triphasé et six portées dans le cas d'un redresseur triphasé.

5. Configuration selon la revendication 1 ou l'une quelconque des revendications 2 à 4,
**caractérisée en ce que**
le corps creux (1), en direction axiale, est sensiblement aussi long que le condensateur (7) ou le système de condensateurs.

6. Configuration selon la revendication 1 ou l'une quelconque des revendications 2 à 5,
**caractérisée en ce qu'**
il est prévu une enveloppe (21) cylindrique ou parallélépipédique, qui entoure en les enfermant à la fois le corps creux servant de support (1) et les éléments qu'il contient et qu'il porte (7, 10, 11, 15, 16, 17, 18), à l'exclusion des contacts de raccordement nécessaires (8, 9, 12, 13, 14).

7. Configuration selon l'une quelconque des revendications précédentes,
**caractérisée en ce que**
le corps creux (1) sert également de support à des platines électriques (17, 18).

8. Configuration selon la revendication 7,
**caractérisée en ce que**
des platines électriques (17) de commande des éléments de puissance à semi-conducteurs (10, 11) sont prévues sur la surface externe et sur les conducteurs électriques de liaison (15, 16) de ces éléments (10, 11).

9. Configuration selon la revendication 7 ou 8,
**caractérisée en ce qu'**
au moins une platine électrique de commande (18) peut être prévue et montée sur une face frontale ou sur les deux faces frontales du support (1) en forme de corps creux.

10. Configuration selon l'une quelconque des revendications précédentes,
**caractérisée en ce que**
le corps creux (1) est équipé de canaux de refroidissement (2) appropriés, disposés de manière appropriée, et dans ces canaux (2) on peut faire circuler notamment un agent réfrigérant liquide.

11. Configuration selon la revendication 10,
**caractérisée en ce que**
le corps creux (1) porte sur sa face frontale une partie de support (6) contenant des canaux de refroidissement (5), cette partie assurant la liaison entre eux de canaux de refroidissement (2) prévus dans la paroi du support (1) et donnant au support (1) à corps creux la forme d'un pot.

12. Configuration selon l'une quelconque des revendications précédentes,
**caractérisée en ce qu'**
elle est prévue pour être utilisée dans un véhicule automobile classique, ou dans un véhicule électrique ou dans un véhicule hybride ou dans un entraîneur à générateur et démarreur.
